# EUROPEAN PATENT APPLICATION

(11) **EP 2 837 459 A1**
(43) Date of publication of application: **18.02.2015**
(21) Application number: 13004089.2
(22) Date of filing: 17.08.2013
(51) Int. Cl.: B23K 3/08, H01L 31/18, B05B 5/03, B05B 7/02

(54) **Systems and methods for applying particles in a gas flow to a workpiece**

(71) Applicant: Somont GmbH, 79224 Umkrich (DE)
(72) Inventor: Blaszczack, Wlodzimierz, 79111 Freiburg (DE)
(74) Representative: Patentbüro Paul Rosenich AG

(57) **Abstract**

The invention relates to an application nozzle (1) for flux. The nozzle is beneficially used for soldering ribbons to solar cells and can apply a flux agent to an elongated area on the cell in time parallel. The nozzle uses centrifugal as well as electrostatic forces to move the agent toward the workpiece (2). The charge difference between the cell and the agent make the latter stick to the surface of the workpiece.

## Description

The invention relates in general to the application of particles in a gas flow to a workpiece and especially to application nozzles, application nozzle units, systems, stringers and methods for doing so. The invention may be used for applying particles with an electrical charge other than the charge of the workpiece. The inventive devices may be suited to be connected to a gas flow containing the particles. The charge of the particles may be altered in the nozzle or elsewhere in the system.

The inventive idea is especially suited for applying flux in powder form used for soldering or brazing in solid form to a workpiece to be soldered. The nozzle is especially designed for applying flux in time parallel to a large region of a workpiece, particularly in a structured manner. Moreover, the nozzle is especially suited for applying particles to one or multiple elongated areas in time parallel.

The invention is suited for providing a solar cell, also called photovoltaic cell, with a solder ribbon, wire or any other interconnector. In order to manufacture solar modules that can for example be placed on a roof of a building for solar energy generation, several solar cells normally with bus bars are typically connected in series to form so called strings. Nowadays strings may meander forming two dimensional parts of or even the complete matrix. For this the solar cells are electrically interconnected with neighboring solar cells by means of solder ribbons or wires. Solder ribbons are thereby normally connected to the positive terminal of a solar cell and to the negative terminal of the neighboring solar cell, i.e. for normal solar cells (no back contact cells) the solder ribbon is alternatingly connected with the lower side of one solar cell and with the upper side of the neighboring solar cell. The solder ribbons are typically made of copper coated with solder and connected with the bus bars by means of one or more soldering units. A solar cell can have several bus bars, normally three to five, which requires an equal amount of solder ribbons for forming the string. The strings are formed in an apparatus called stringer or tabber or tabber-stringer. A stringer interconnects cells, a tabber only connects the interconnectors to the cells and a tabber-stringer does both. The inventive system may be part of any system for attaching interconnectors to a solar cell.

When interconnecting solar cells by brazing or soldering normally flux is applied to facilitate this process. It has been realized that preferably flux should be applied to regions where the solder joint is made only and that flux may be applied without being dissolved in a solvent. See WO2011033451A2 and WO2012069995A2 respectively, which are herewith incorporated in this application by reference. Any inventive idea described in this application may also be combined with subject matter from these two applications.

GB1549 805 discloses an electrostatic powder painting apparatus comprising a powder gun which has the general form of a cyclone separator including a casing having a cylinder composed of an insulating material (for example, glass or plastics) and a conical section, an internal cylinder supported by a ring-like end plate arranged concentrically with the casing, an inlet for powder, containing gas, and a powder discharging port 8. The internal cylinder 6 has an end plate and an outlet for the gas. A needle-like corona discharge electrode is supported by an insulated cylinder which is in tum supported to the freely slidable longitudinally by the end plate. As the particles move along with the flow of air they are forced by the centrifugal force of the rotation of the air in space 38 towards the inner wall 41, where they are forced to the discharge opening by a stream of air. The force exerting the particles from the gun is thus caused by the flow of the air and the electrostatic field.

In order for the centrifugal force in the space 38 to be large enough to separate the particle from the flow of air, the same flow has to be fast enough which in turn gives the particles little time to be collected. This results in numerous particles being drained into outlet 10. These particles are lost or need to be recollected.

Further this powder gun is not suitable for applying powder to a large area in time parallel, especially when that area is elongated. Since the separation of the particles depends on the rotary movement of the air flow, the inner wall 41 of the space 38 has to be cylindrical or conical and cannot be for example too oblong since this would destroy the spiraling of the air.

US 3,976,031, which is considered the closest state of the art, discloses a face-silent discharge electrode which includes plural parallel electrode bars separated from each other at a distance and arranged in a face that is disposed to confront a substrate. A powder coating material is supplied in the space between said electrode and said substrate. An AC voltage is impressed on the electrode bars adjacent each other to generate a silent electric discharge over the entire surface of said face-silent discharge electrode. Concurrently, a DC voltage is impressed between the electrode bars and the substrate so that the powder coating material may adhere to a surface of the substrate to form a layer of uniform thickness.

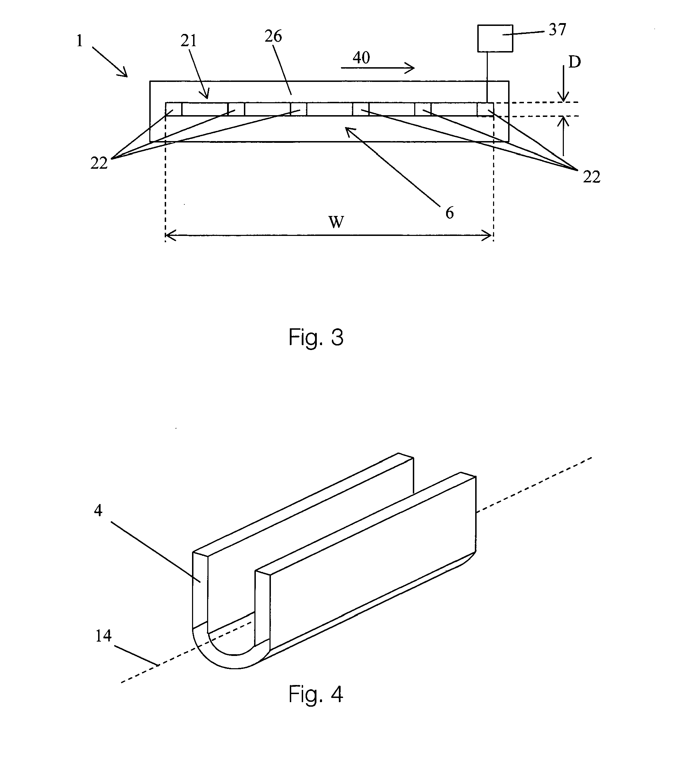

As can be seen from the embodiment shown in for example figures 4a and 17a, the particles are expelled from the gas by means of the electrical field. In this way the particles are not expelled from the system efficiently and will be lost or have to be collected to be re-used, as can be seen from the duct that is a closed loop in figure 4a.

In both embodiments, the particles are not applied evenly. In Figure 4a more particles will be applied near duct 16 since here there are more particles in the stream. In Figure 17a only in the range near the end of passage 18 (close to the line of reference number 18) the particles experience an additional centrifugal force towards the workpiece. If the dimensions of the system and the speed of the gas flow are such that this leads to a noticeable effect on the particles, relatively more particles will be deposited in this range and this region only.

Thus the state of the art does not disclose a system for efficiently applying all particles from a gas stream and applying them to an elongated area in a homogenous manner.

It is the goal of the current invention to provide a system that can deposit particles more homogeneously over a large range, especially an elongated area, while in doing so removing almost all particles from the gas stream, so that no recollection of particles is needed or at least very few particles need to be recollected or disposed of. In addition the particles may be applied in a structured manner. The invention is especially aimed at applying particles to solar cell, wafer and intermediate stages thereof, but it is not limited to these goods.

This object is achieved by means of an application nozzle for dispensing material such as a flux agent suspended in a gas flow, comprising a duct for guiding the gas flow towards and away from a dispensing opening, the duct having a curved portion which is delimited in its outside bend by a wall portion. The dispensing opening being provided directly adjacent or preferably in that wall portion such that material suspended in the gas flowing through the curved portion experiences a centrifugal force directed towards that wall portion, preferably towards that dispensing opening .

Preferably the wall portion itself has a finite radius at least upstream of the discharge opening so that the centrifugal force works on the particles all the way up to the opening. For ease of manufacturing, the bend may however also be less smooth and may for example be rectangular or obtain rectangular portions. Moreover, the bend in the duct for example up stream of the dispensing opening may contain or consist of two straight walls, preferably being perpendicular to each other, the downstream wall preferably having the dispensing opening arranged in it. It was found that the particles are move towards the outside bend well enough. The bend or outer wall portions may be made of one piece of material, preferably an electrically insulating material. The wall portion containing the dispensing opening may be readily replaceable thus allowing quick changing of the used mask for example for cleaning or for altering the pattern of the applied material.

In order for the centrifugal force to have its desired effect, the opening must be located in the outside bend. With duct the hollow channel guiding the flow of gas is meant. The dispensing opening is located downstream of at least part of the wall portion.

Preferably the curved portion is further delimited in its inside bend by an inside wall portion that is curved in the same direction as the wall portion. Curved meaning the way the whole duct or wall is bent in that region. Locally the wall may for example be straight. Multiple such straight portions however may form the curved portion.

The curved portion preferably is a bend in the duct, meaning that curved sides of the duct globally have the same curvatures: both rotate around a point on the same side of the duct. Curved sides meaning the sides or walls seen when looking in the plane the duct bends in or put differently in the plane perpendicular to the rotational axis (see below) the stream of air is rotated around. One of the sides or walls thus forming the outside bend and one an inside bend.

Preferably the cross-section of the duct remains more or less unchanged in the curved portion, the cross-sectional area for example not changing by more than a factor four. The cross-sectional area may get smaller in the direction of flow of the gas as to further increase the speed of the gas flow and thus the centrifugal force acting on the suspended particles.

The discharge opening may be located downstream of the wall portion, preferably close of adjacent the wall portion or even in the wall portion so that the centrifugal force works on and accelerates the particle all the way up to the opening, not giving them time to decelerate or even move away from the outside bend for example by diffusion or turbulence.

The term centrifugal force is used loosely in this document. The particles do not experience an actual force pushing them toward the dispensing opening: the centrifugal force is an inertial or fictitious force. The particles only accelerate relative to the gas (an observer moving along with the gas stream) because of their inertia. It is this acceleration and deceleration relative to the flow of gas that is used.

Preferably the centrifugal force gives the particles a speed mainly perpendicular to the wall portion, at least adjacent to the dispensing opening.

The centrifugal force experienced by the particles will accelerate them towards the wall portion in the outer bend. In order to discharge the particles as perpendicularly as possible out of the opening, it is beneficial when the centrifugal force points in a direction perpendicular to that wall and downstream of the wall perpendicular to the plane the opening extends in. This may be achieved by giving the wall portion a continuous radius of around 3 to 8mm. Preferably the duct extends in a continuous manner near the discharge opening.

The material suspended in the flow of air may be a flux agent used for soldering or brazing. Such agents may contain or consist of at least any of the group of carbon acid, such as Dicarbon acid, Adipic- Succinic-, Glutaric-, Pimelic-, Suberic-, Lactic-, citric-, steraic-, cyclohexanecaerboxylic acid, another acid with the right physical and chemical properties or any combination thereof. Preferably the flux agent is suspended in the stream of air in its solid state, thus overcoming the need to heat up the agent. It however may also be present as droplets or in any other form.

The gas flowing through the system may be any suitable gas and preferably is air or compressed air. If desired the gas may be a protective gas such as an inert gas to protect system parts, the workpiece, the material suspended in it or any combination thereof.

Preferably less than 30%, even more preferred less than 10% of the gas flow flows out of the discharge opening. The nozzle may also be abutted on the workpiece to be coated. In that way virtually no gas leaves the application opening. The air flow may be driven by a pressure of 3 bar and may be pulsed, only flowing for example when the application nozzle abuts the workpiece.

Preferably the curved portion rotates the direction of the gas flow around a rotational axis extending in an angle relative to the plane the discharge opening extends in or the front surface of a work piece to be coated, that angle being smaller than 10°, preferably smaller than 5° even more preferred the angle is essentially 0°, the opening extending in a plane parallel to the rotational axis. If the object to be coated or at least its surface to be coated is mainly flat, such as is the case for solar cells, the axis extends in this angle relative the front surface of the object. The plane the opening extends in according to the invention preferably extends mainly parallel to the plane of the front surface of the workpiece to be coated. By changing the (macroscopic) direction of flow this way or at least its component of movement towards the workpiece, the centrifugal force moves particles suspended in the gas flow towards the opening and thus the workpiece in a homogeneous manner over the whole area of the opening, regardless of size of that opening.

Alternatively, the curved portion may rotate the direction of the component of movement towards the opening of the gas flow perpendicular to the plane the opening extend in or perpendicular to the front surface of a work piece to be coated around a rotational axis extending in an angle relative to the plane the discharge opening extends in or the front surface of a work piece to be coated, that angle being smaller than 10°, preferably smaller than 5° even more preferred the angle is essentially 0°. In that way particles will still be propelled towards and away from the opening and thus workpiece in a completely homogenous manner over the whole opening, while loosening design constraints.

The centrifugal force is preferably directed mainly perpendicular to that rotational axis, at least near the opening or over the opening. In the latter case, the opening may be obstructed by the workpiece to be coated or the opening may just be small enough to bend most of the gas flow as to continue its flow through the duct, thus generating the centrifugal force.

The opening may be covered with a mask, preferably the mask being chargeable with third charge alternating means. In this way the suspended material, also called particles may be applied to a large area with the exemption of those masked regions, thus forming a 1 D or 2D pattern. The mask may be interchangeable and be easily detached from the rest of the system so that it may be adapted to the pattern the material should be deposited in. For example, when soldering discrete locations, the material may only be provided to those locations. When applying material to multiple wires extending in front the opening that for example move in a direction perpendicular to the direction the opening extends in, material may only be applied to those wires. A 1D or 2D pattern may also be achieved by pulsing the flow of air while changing the relative position of the nozzle and the workpiece.

In order to prevent material from attaching itself to the mask, the electrostatic charge of the latter may be controllable, as was stated above. By giving the mask or the edges of the discharge opening the same charge as the material suspended in the gas flow, it is prevented that the material attaches itself to these members. By given the material and parts of the system a charge of same polarity, they even repel each other thus preventing clogging even further. Letting gas flow through the system without particles suspended in it may help top remove undesired particles attached to system parts.

Especially solar cells have to be coated with for example a flux agent over an elongated area, preferably intermittently by means of a mask. The duct may therefore have an oblong, preferably mainly rectangular cross-section for forming a sheet of gas flowing towards the opening. In order to achieve the desired homogenous application, the discharge opening may have an oblong shape, mainly extending in a first direction, this direction being mainly parallel to the direction the rotational axis extends in. By doing so the centrifugal forces act by the same amount and in the same way regardless of to position of a particle in the opening. Preferable a sheet of gas flowing past the opening is created that ideally does not flow in the direction of that rotational axis and only bends around the rotational axis forming a U-shape, at least near the opening.

Preferably the particles only experience a centrifugal force in the desired direction: towards the outer bend of the curved wall. Moreover, if the particles are distributed equally over the gas flow before reaching the curved portion, they will not be redistributed in the direction of the rotational axis. Preferably the macroscopic speed of the gas near the opening only has a component perpendicular to the rotational axis. This is achieved by the direction the duct extends in: it should have little or no component parallel to the rotational axis, at least near the curved portion.

In order to better apply the material to the workpiece and especially to make the material stick to the workpiece the inventive nozzle may contain charge altering means for altering the electrostatic charge of the suspended material, the means preferably being located in the duct upstream of the dispensing opening. As long as the suspended material has a charge different from the workpiece, it is attracted there to. The material may be made neutral in the system (or may already be neutral) and thus applied to a charged workpiece. The workpiece may have no net charge and may only have a charge on its surface to be coated, created for example by influence. Preferably the charge altering means are located at a distance (say more than 5 or more than 15 mm) from the curved portion so that the particles are surely charged when they reach the opening.

The charging means for altering the electrostatic charge of the particles may support a DC voltage, AC voltage or any combination thereof. The corona discharge effect may be used, the particles may touch the charging means in order to pick up or donate charge or electrostatic induction may be used, the particles being grounded in one way or the other. These processes may be stimulated or achieved solely by non-electrical means such as a source for UV-radiation or friction.

If needed the exiting of the particles may be supported further by an electrical field other than that originating from the charge difference between the particles and the workpiece. This is for example known from the above cited US 3,976,031. Electrodes for this may be integrated in the inventive system.

The inventive system(s) may be used for dispensing materials onto a workpiece, preferably over a larger area of that workpiece in time parallel (meaning that the position of the system does not have to be changed in order to coat the whole desired area). The workpiece may be mainly flat in at least one direction. Typical workpieces are solar cells, wafers or the like or wires or interconnectors for example used for interconnecting solar cells. Such workpieces may be coated efficiently by using a discharge opening and/or duct having a cross-section with a width larger than its depth, preferably the width being at least 10 times larger ten the depth, even more preferred at least 20 times larger. The width may for example be 150mm or larger while the depth is 5mm or smaller. Such dimensions agree with needs of the solar industry where elongated wires or ribbons are connected to elongated contact areas on solar cells. Moreover elongated areas on ribbons, wires and cells need to be coated. Such a contact area may for example be a bus bar or any region (possibly without metallization) suitable for connecting interconnectors to. It may also be an array (1 D or 2D) of portions of fingers on the solar module. In both cases flux may be applied selectively. In the former case because the ribbon may be soldered to the bus bar in discrete points, in the latter case because it should be prevented as much as possible that flux is applied next to the fingers on the sensitive area of the cell. The width preferably extending in the direction of the rotational axis or in the first direction the dispensing opening extends in.

In a further aspect of the invention, an application nozzle unit is provided containing multiple inventive application nozzles, the application nozzle preferably being arranged side-by-side so that their respective rotational axes are mainly in parallel. By integrating multiple application nozzles, space can be saved, while enabling to apply all material necessary in time parallel. For example all bus bars of a solar cell (normally parallel to each other) may be coated at once, thus decreasing production time. Also multiple ribbons or connection wires may be coated at once.

In a further aspect of the invention, a system is provided containing an inventive application nozzle or application nozzle unit, further comprising a base for holding a workpiece, preferably for holding a solar cell, wafer, ribbon or interconnector, the base preferably being connected to charge altering means for controlling the electrostatic charge of the workpiece.. It may further comprise a transportation system such as a conveyer belt for transporting the workpiece to the application nozzle(s). It may also comprise a source for gas with material suspended in it for being connected to the application nozzle or application nozzle unit.

Preferably the system comprises means for moving the application nozzle or application nozzle unit and the base or workpiece relative to each other, preferably so that the application nozzle or application nozzle unit can be brought into contact with the base or workpiece. In that way the distal end of nozzle may be pressed against the workpiece, thus further reducing the flow of air out of the discharge opening.

In a further aspect of the invention a stringer, tabber or tabber stringer is provided containing any of an inventive application nozzle, application nozzle unit, system or any combination thereof.

In a further aspect of the invention a method is provided for applying material to a workpiece, the method comprising the steps of:
- locating the application nozzle near a workpiece to be coated
- generating a flow of gas through the duct of that nozzle with particles suspended in that gas,
   preferably in that order. Preferably the method further comprises at least one of the following steps:
- moving the application nozzle towards the workpiece or vice versa preferably as to abut on each other; or
- preferably controlling the charge of particles, the workpiece or both

By abutting the nozzle on the workpiece, virtually no air will leave the application nozzle through the discharge opening thus preventing material from being carried away from the actual location it has to be applied and reducing the need for cleaning the workpieces, the application nozzle or system it is integrated in.

The inventive nozzle may preferably be integrated in or form a spray gun or face-silent discharge electrode. It may be used for any kind of coating and painting.

Further embodiments of the invention are indicated in the figures and in the dependent claims. The list of reference marks forms part of the disclosure. The invention will now be explained in detail by the drawings. In the drawings:
Fig. 1 schematically shows a cross sectional view of an embodiment of an application nozzle according to the invention and a workpiece on a base;
Fig. 2 shows the distal end of an embodiment of the inventive nozzle;
Fig. 3 shows an embodiment of the distal end of an embodiment of the inventive application nozzle from below;
Fig. 4 shows the shape the gas flow may have according to the invention in relation to the rotational axis
Fig. 5 schematically shows an application nozzle unit; and
Fig. 6 schematically shows a tabber-stringer using an inventive application nozzle unit.

The present invention will be described with reference to exemplary embodiments and the present invention is not limited to a particular embodiment or component parts thereof, except as defined in the appended claims. Embodiments of the present invention may be used with a variety of methods and systems. It will be apparent to one skilled in the art that the present invention may be practiced in a variety of ways within the scope of the claims. Any feature shown in relation to the figures may be applied in general to the invention as described in the claims.

As used herein, the indefinite article ("a", "an") denotes the presence of at least one of the referenced item, and the term 'a plurality' denotes the presence of more than one.

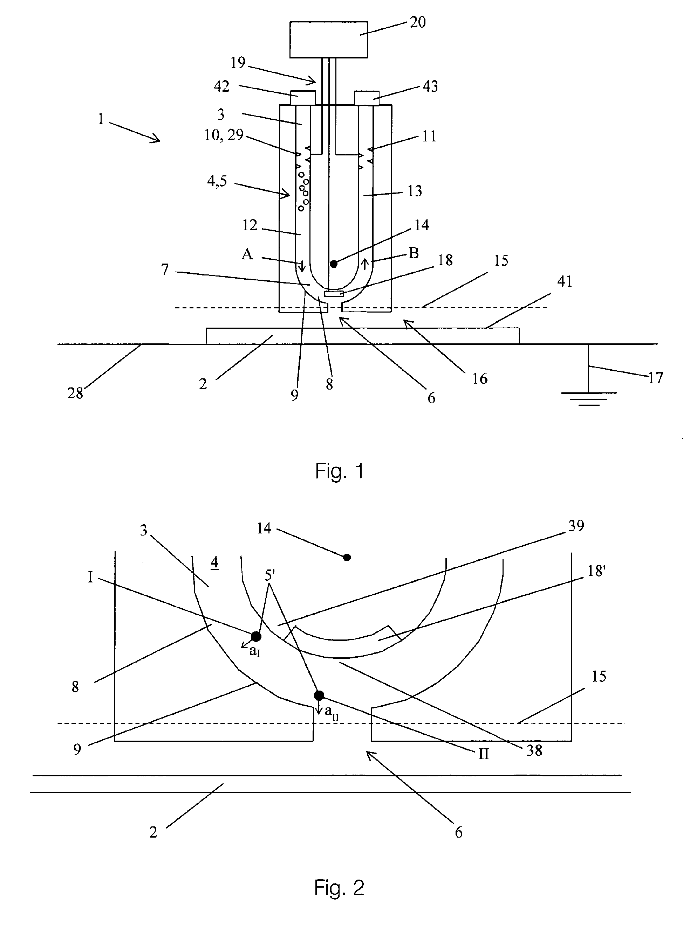

Figure 1 shows a cross-sectional view an embodiment of the inventive application nozzle 1 for coating a workpiece 2 such as a wafer, a solar cell, one or more ribbons or wires or any other object(s). A workpiece 2 is placed near the distal or dispensing end 16 of the nozzle 1. The distal end 16 may also abut on the front surface 41 of the work piece 2. A duct 3 transports particles 5 suspended in a flow of gas 4 towards a dispensing opening 6. Only a few particles 5 are shown. The gas flow 4 extends in the whole duct. Particles 5 are mainly supported upstream 12 of the dispensing opening 6. Downstream 13 of opening 6 only very few particles remain in the gas stream 4. The opening extends in plane 15.

The flow of gas 4 changes its direction as a consequence of the duct 3 making a bent or curve in its curved portion 7. An outer wall portion 9 of the outside bend 8 of duct 3 exerts force on the gas 4 thus changing its direction from A to B, effectively rotating the flow around rotational axis 14.

Means for altering the electrostatic charge 10 of the material 5 suspended in the gas 4 are provided in the duct 3. If the electrostatic charge of the particles 5 differs from the charge of the workpiece 2, the particles will stick to the workpiece. In general, charge altering means may be used to change or control the electrostatic charge of the particles 5. In the shown embodiment, particles are charged, negatively or positively, and the workpiece is grounded to give it a neutral charge. What charge the particles and the workpiece have is not relevant. As long as the charges are different, the particles will stick to the workpiece. This works particularly well when the particles are electrical insulators. Typically the controller 20 charges the particles with a charge of at least 1 kV, e.g. 7 kV. The workpiece 2 is kept uncharged by ground connection 17 of the base 28.

In the shown embodiment, the first charge alternating means 10 also form diffusor means 29. Diffusor means homogenize the flow of gas 4 and distribute the particles 5 more evenly in the gas 4.

As the gas flow 4 flows through the duct 3, it flows through the curved portion 7 and experiences a centripetal force. The particles 5 - which are free to move in the gas - will accelerate towards the outer wall portion 9 of the bend 7 under influence of the centrifugal force. This will be explained in more detail in relation to figure 2.

As the flow of air 4 passes the dispensing opening 6, it travels further towards second charge altering means 11. These means may make the remaining particles electrically neutral in order not to transport electrostatic charge to the surroundings. They may also be part of a recollection system: by giving the charge altering means a charge different from the charge of the particles, the particles will stick to them. A recollection system may for example be used to recollect particles if the system is not operating correctly or for example during set-up when the particles are not charged correctly. It may also be used the few particles that do not leave the dispensing opening 6. However few particles these are, over the years, particles may accumulate in undesired places.

By making the charge of the first 10 and or second 11 charge alternating means equal to the charge of the particles 5 when no gas flows or no particles are present in the gas flow, particles may be removed from the first 11 and or second 12 charge alternating means respectively. The first and or second charge alternating means may use any known technology for (de-)charging particles. A controller 20 is attached to the first and or second charge alternating means by connection wires for controlling them. If the first and or second charge alternating means are merely electrodes, the wires 19 support the currents and voltage used for (de-)charging.

An additional electrode 18 is provided to give the particles 5 an additional acceleration towards the dispensing opening 6 and thus towards the workpiece 2.

A connector 42 for connecting the nozzle 1 to a source for gas is shown as well as a connector 43 for an outlet o the gas.

Figure 2 shows how a single particle 5' at two different times is accelerated relative to the gas towards the dispensing opening 6 extending in plane 15. The arrows a_{I} and a_{II} indicate the direction of the respective accelerations. As the particle 5' moves from a first position I towards a second position II, rotating around rotational axis 14, the inertia of the particle makes the particle move towards the outside bent 8 and the wall portion 9. Since the gas 4 is accelerated towards the rotational axis 14 perpendicular to the plane of the drawing (by wall portion 9), the particle 5' experiences a force (drag) away from the wall portion 9. Nevertheless, a net particle transport towards the outside bend 8 and finally the dispensing opening 6 will take place. The gas 4 near the dispensing opening 6 will therefore contain a much higher particle concentration then the average particle concentration in the duct 3.

As the particle 5' moves past the dispensing opening 6, it comes under the influence of the electrical field of the workpiece 2. This electrical field may be created by the charge of the particle 5', by an additional electrode 18', the charge of the (electrically insolated) base, the workpiece 2 or a combination thereof. In the embodiment of figure 2, the electrode 18' is integrated in the wall 39 of the inside bend 38 of duct 3, so that the flow of gas is not hindered.

Figure 3 shows an inventive nozzle 1 in the direction looking upward from the workpiece 2 and perpendicular to the plane 15 the opening 6 extends in (see figure 2). The dispensing opening 6 is an elongated slit (width W, extending in a first direction 40 and depth D) that in this embodiment is masked with a mask 21 with openings 22. The particles 5 leave the stream of gas only through the openings 22. The mask 21 is attached to charge alternating means 37. By giving the mask 21 the same charge as the particle, the latter will not deposit on the mask.

Figure 4 shows the general shape of the flow of gas 4 according to the invention (not showing the housing delimiting the duct): an elongated U-shape. The duct 3 bends around the rotational axis 14. The duct 3 has the dispensing opening (not shown) near the bottom of the U. The U-shape does not have to be as smooth as in the embodiment shown and may for example be rectangular. Moreover the bend in the duct for example up stream of the dispensing opening may consist of two straight walls, preferably being perpendicular to each other.

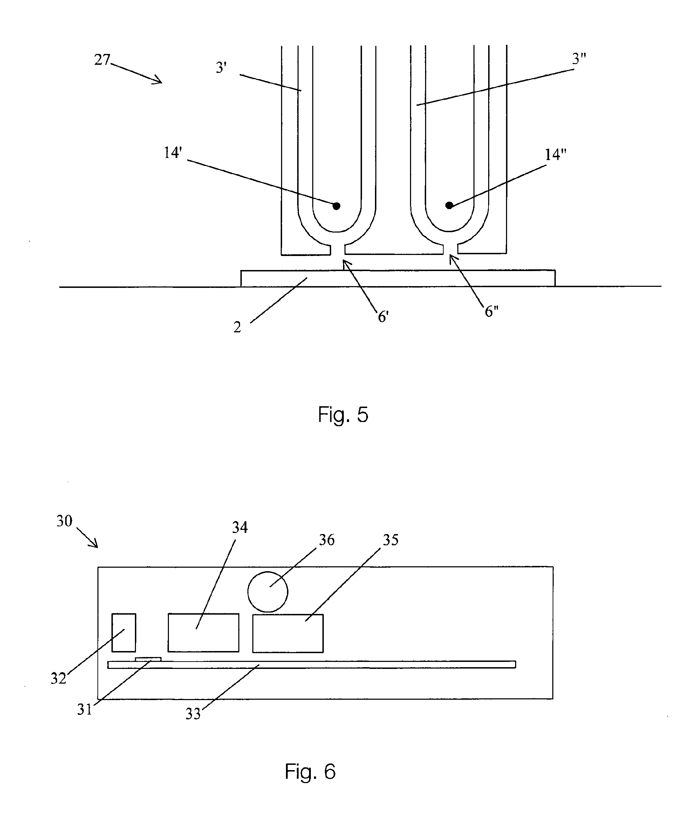

Figure 5 shows an embodiment of an application nozzle unit 27 containing two application nozzles according to the invention with respective dispensing openings 6' and 6". The respective ducts 3' and 3" rotate the respective gas streams around respective rotational axes 14' and 14". In this way, two elongated areas (extending perpendicularly to the plane of the drawing) on a workpiece 2 may be coated in time parallel.

Figure 6 shows an embodiment of a system 30 according to the present invention forming a tabber-stringer 30. Solar cells 31 are retrieved from a storage for solar cells 32. The cells 31 are transported by a conveying unit 33 to a unit 34 containing an application nozzle 1 or application nozzle unit 27 (not shown) according to the invention. The cells are thus locally coated with flux particles. In a next step the cells are moved to a soldering unit 35 where ribbons (not shown) from a ribbon reservoir 36 are soldered to the cells 31. The ribbons are selectively connected to one or two cells 31 thus forming a string of solar cells (not shown).

The invention is not restricted to the embodiments shown. Single or multiple combinations thereof are possible. Features of the shown embodiment may also be applicable to other concepts and embodiments, shown and not shown in the figures, and more particularly to the invention as described in the claims.

**List of reference signs**

| | | | |
|---|---|---|---|
| 1 | Application nozzle | 25 | Outer wall portion |
| 2 | Workpiece | 26 | Front wall |
| 3 | Duct | 27 | Application nozzle unit |
| 3' | Duct | 28 | Base |
| 3" | Duct | 29 | Diffusor means |
| 4 | Gas, gas stream, flow of gas | 30 | System, Stringer, tabber, tabber stringer or device for interconnecting strings |
| 5 | Particles | | |
| 5' | Particle | | |
| 6 | Dispensing opening | 31 | Solar cell |
| 6' | Dispensing opening | 32 | Storage |
| 6" | Dispensing opening | 33 | conveying system |
| 7 | Curved portion of the duct | 34 | unit with application nozzle |
| 8 | Outside bent | 35 | soldering unit |
| 9 | Wall portion | 36 | Ribbon reservoir |
| 10 | First charge alternating means | 37 | Third charge alternating means |
| 11 | Second charge alternating means | 38 | Inside bend |
| 12 | upstream | 39 | Inside wall portion |
| 13 | downstream | 40 | First direction |
| 14 | Rotational axis | 41 | Front surface of workpiece |
| 14' | Rotational axis | 42 | Connector for inlet for gas flow |
| 14" | Rotational axis | 43 | Connector for outlet for gas flow |
| 15 | Plane the dispensing opening extends in | | |
| | | a_{I} | Direction of acceleration in position I |
| 16 | Distal end of nozzle | | |
| 17 | Ground connection | a_{II} | Direction of acceleration in position II |
| 18 | Electrode | | |
| 18' | Integrated electrode | A | Flow towards the dispensing opening |
| 19 | Connection wires | | |
| 20 | Controller | B | Flow away from the dispensing opening |
| 21 | Mask | | |
| 22 | opening in mask | D | Depth of the duct |
| 23 | Divider wall portion | I | First position of particle |
| 24 | Outer wall portion | II | Second position of particle |
| | | F_{CF} | Centrifugal force |
| | | W | Width of the duct |

## Claims

1. Application nozzle (1) for dispensing material (5) such as a flux agent suspended in a gas flow (4), comprising a duct (3, 3', 3") for guiding the gas flow (4) towards (A) and away (B) from a dispensing opening (6, 6', 6"), the duct (3, 3', 3") having a curved portion (7) which is delimited in its outside bend (8) by a wall portion (9), **characterized in that** the dispensing opening (6, 6', 6") is provided directly adjacent or preferably **in that** wall portion (9) such that material (5) suspended in the gas (4) flowing through the curved portion (7) experiences a centrifugal force (F_{CF}) directed towards that wall portion (9), preferably towards that dispensing opening (6, 6', 6").

2. Application nozzle according to claim 1, the curved portion (7) being delimited in its inside bend (38) by an inside wall portion (39) that is curved in the same direction as the wall portion (9).

3. Application nozzle according to any of the preceding claims, **characterized in that** the curved portion (7) rotates the direction of the gas flow around a rotational axis (14, 14', 14") extending in an angle relative to the plane (15) the discharge opening (6, 6', 6") extends in or the front surface (41) of a work piece (2) to be coated, that angle being smaller than 10°, preferably smaller than 5° even more preferred the angle is essentially 0°.

4. Application nozzle according to any of the preceding claims, **characterized in that** that the curved portion (7) rotates the direction of the component of movement towards the opening (6, 6', 6") of the gas flow perpendicular to the plane the opening extend in or perpendicular to the front surface of a work piece (2) to be coated around a rotational axis (14, 14', 14") extending in an angle relative to the plane (15) the discharge opening (6, 6', 6") extends in or the front surface (41) of a work piece (2) to be coated, that angle being smaller than 10°, preferably smaller than 5° even more preferred the angle is essentially 0°.

5. Application nozzle according to any of the preceding claims, **characterized in that** the duct (3, 3', 3") has an oblong, preferably mainly rectangular cross-section for forming a sheet of gas flowing towards the opening.

6. Application nozzle according to any of the preceding claims, **characterized in that** the discharge opening (6, 6', 6") has an oblong shape, mainly extending in a first direction (40) mainly parallel to the direction the rotational axis (14, 14', 14") extends in.

7. Application nozzle according to any of the preceding claims, characterized that it contains charge altering means (10, 11) for altering the electrostatic charge of the suspended material, the means preferably being located in the duct (3).

8. Application nozzle according to any of the preceding claims, characterized that the discharge opening (6, 6', 6") and/or the duct (3, 3', 3") has a cross-section with a width larger than its depth, preferably the width being at least 10 times larger ten the depth, even more preferred at least 20 times larger.

9. Application nozzle according to any of the preceding claims, **characterized in that** the discharge opening is covered with a mask (21), preferably the mask (21) being chargeable with third charge alternating means (37).

10. Application nozzle unit (27) containing multiple application nozzles according to any of the preceding claims, the application nozzle preferably being arranged side-by-side so that their respective rotational axes (14', 14") are mainly in parallel.

11. System (30) containing an application nozzle (1) or application nozzle unit (27) according to any of the preceding claims, further comprising a base (28) for holding a workpiece (2), preferably for holding a solar cell, wafer, ribbon or interconnector, the base preferably being connected to charge altering means (17) for controlling the electrostatic charge of the workpiece (1).

12. System (30) according to claim 11, comprising means for moving the application nozzle (1) or application nozzle unit (27) and the base (28) or workpiece (2) relative to each other, preferably so that the application nozzle (1) or application nozzle unit (27) can be brought into contact with the base (28) or workpiece (2).

13. Stringer, tabber, tabber stringer or device for interconnecting strings (30) containing any of an inventive application nozzle (1), application nozzle unit (34), system (30) or any combination thereof.

14. Method for using an application nozzle as defined in any of the preceding claims, comprising:
- locating the application nozzle (1) near a workpiece (2) to be coated; and
- generating a flow of gas (4) through the duct (3, 3', 3") of that nozzle (1) with particles (5) suspended in that gas (4).

15. Method according to claim 14, comprising at least one of the following steps:
- moving the application nozzle (1) towards the workpiece (2) or vice versa preferably as to abut on each other;
- preferably controlling the charge of particles (5), the workpiece (2) or both;
